# FASCICULE DE BREVET EUROPEEN

(11) **EP 3 663 752 B1**
(45) Date de publication et mention de la délivrance du brevet: **05.04.2023**
(21) Numéro de dépôt: 19213402.1
(22) Date de dépôt: 04.12.2019
(51) Int. Cl.: G01N 29/02, G01N 29/036

(54) **CAPTEUR DE FLUX THERMIQUE A NANOFILAMENTS CHAUFFANTS**
THERMISCHER FLUSSSENSOR MIT HEIZBAREN NANODRÄHTEN
THERMAL FLUX SENSOR WITH HEATING FILAMENTS

(30) Priorité: 07.12.2018 FR 1872516
(43) Date de publication de la demande: 10.06.2020
(73) Titulaire: COMMISSARIAT À L'ÉNERGIE ATOMIQUE ET AUX ÉNERGIES ALTERNATIVES, 75015 Paris (FR); APIX Analytics, 38000 Grenoble (FR)
(72) Inventeur: OLLIER, Eric, 38054 GRENOBLE CEDEX 09 (FR); ALAVA, Thomas, 38054 GRENOBLE CEDEX 09 (FR); BENEDETTO, Kévin, 38054 GRENOBLE CEDEX 09 (FR); LADNER, Carine, 38054 GRENOBLE CEDEX 09 (FR); COLINET, Eric, 38330 Saint Ismier (FR)
(74) Mandataire: Regimbeau

(56) Documents cités:
- EP-A1- 2 711 696
- XU WEIHONG ET AL: "Fabrication of Prototypal Nanomechanical Resonator Based on a Single Copper Nanowire", 2013 IEEE INTERNATIONAL CONFERENCE ON GREEN COMPUTING AND COMMUNICATIONS AND IEEE INTERNET OF THINGS AND IEEE CYBER, PHYSICAL AND SOCIAL COMPUTING, IEEE, 20 août 2013 (2013-08-20), pages 1706-1709, XP032530574, DOI: 10.1109/GREENCOM-ITHINGS-CPSCOM.2013.313

## Description

### DOMAINE DE L'INVENTION

La présente invention concerne un capteur de flux thermique à nanofilaments chauffants. Un tel capteur de flux thermique peut trouver une application notamment dans un capteur de gaz, un système d'analyse de gaz ou un débitmètre.

### ETAT DE LA TECHNIQUE

Un capteur de flux thermique permet de mesurer un échange de chaleur entre le corps du capteur et son milieu environnant. Le milieu environnant peut être un milieu gazeux ou liquide. Cette approche peut être utilisée pour réaliser par exemple un capteur de gaz ou un capteur de pression.

Un capteur de gaz de type TCD (acronyme du terme anglo-saxon « Thermal Conductivity Detector » ou « détecteur à conductivité thermique ») fonctionne sur le principe de la mesure de la résistance électrique d'un fil dont la température varie en fonction des échanges de chaleur avec un gaz environnant au travers de la conductivité thermique dudit gaz. Un tel capteur est décrit notamment dans le document US 8,313,236.

Un tel capteur peut être agencé à la sortie d'une colonne de chromatographie gazeuse au travers de laquelle les différentes espèces constituant un mélange de gaz à analyser sont séparées.

Le capteur comprend un fil chauffant couplé à une source électrique permettant de le chauffer par effet Joule, suspendu dans un volume dans lequel se trouvent une ou plusieurs espèces à détecter.

Selon la nature de l'espèce en contact avec le fil chauffant, et plus précisément sa conductivité thermique, les échanges thermiques entre le fil chauffant et l'espèce sont susceptibles d'engendrer une variation de température du fil chauffant et par conséquent une variation de la résistance électrique du fil.

Ce changement de résistance électrique, ainsi que la résistance électrique d'un fil identique en contact avec un gaz de référence, sont mesurés à l'aide d'un pont de Wheatstone, en vue de déterminer la concentration de l'espèce considérée.

Cependant, cette technologie présente des limites en ce qu'elle nécessite un contraste important en termes de conductivité thermique entre le gaz de référence et la ou les espèce(s) à détecter.

Par ailleurs, le fil est généralement réalisé en platine enrobé par du nitrure, qui sont des matériaux présentant des niveaux de contraintes importants, induisant des difficultés de mise en oeuvre et des limites en termes de conception du capteur. Cette technologie est donc difficile à maîtriser en pratique.

Un autre type de capteur reposant sur le même principe de mesure a été réalisé sur substrat de silicium grâce à des techniques de microfabrication, permettant de graver le fil chauffant directement dans une couche de silicium. Ce type de capteur a été décrit dans les documents FR 2 995 691, FR 2 995 690 et FR 2 995 692. Cette technique présente un avantage en termes de facilité d'intégration.

En revanche, pour avoir une résistance électrique appropriée du fil de silicium, un tel capteur doit être réalisé à l'échelle nanométrique. Il en résulte que la surface d'échange thermique entre le fil chauffant et le gaz à détecter est très faible, ce qui limite lesdits échanges et la capacité du capteur à détecter de faibles concentrations de gaz.

D'autres capteurs reposent sur des technologies différentes.

Par exemple, le document WO 2015/082956 décrit un résonateur de type NEMS (acronyme du terme anglo-saxon « Nano Electro-Mechanical Systems ») permettant la mesure de la concentration de gaz par effet gravimétrique, c'est-à-dire la modification de la fréquence de résonance du résonateur due à une modification de la masse de la structure résonante.

Quelle que soit la technologie considérée, des améliorations sont attendues en termes de sensibilité du capteur et de simplicité de fabrication.

### EXPOSE DE L'INVENTION

Un but de l'invention est de concevoir un capteur de flux thermique qui soit simple à fabriquer, tout en assurant une bonne sensibilité de détection.

A cet effet, l'invention propose un capteur de flux thermique comprenant :
- un réseau de nanofilaments suspendus par rapport à un support, chaque nanofilament comprenant un matériau électriquement conducteur ou semi-conducteur, ledit réseau étant apte à être polarisé par une source électrique pour faire circuler un courant électrique dans chacun desdits nanofilaments,
- au moins un résonateur de type nanosystème électromécanique (NEMS) comprenant :
   * une poutre constituée d'un nanofilament formant un côté du réseau,
   * un dispositif d'actionnement apte à générer une vibration de ladite poutre sous l'effet d'un signal d'excitation,
   * un dispositif de détection configuré pour mesurer un déplacement de la poutre au cours de ladite vibration et émettre un signal de sortie présentant une résonance à la fréquence de résonance du résonateur, ladite fréquence de résonance dépendant de l'intensité du courant électrique traversant la poutre,
   une variation de température du réseau de nanofilaments chauffants induite par une variation d'une caractéristique d'un fluide environnant ledit réseau provoquant une variation de l'intensité du courant traversant la poutre se traduisant par une variation de la fréquence de résonance dudit résonateur.

Par « nanofilament » on entend dans le présent texte un filament de taille nanométrique, c'est-à-dire dont l'une des dimensions transversales (par exemple le diamètre s'agissant d'un filament rond, ou la largeur s'agissant d'un filament à section rectangulaire) est inférieure ou égale à quelques centaines de nm, par exemple inférieure à 500 nm.

Un tel capteur repose sur le fait que la fréquence de résonance du résonateur dépend fortement de l'intensité du courant électrique qui le traverse.

Ce capteur bénéficie de la précision de mesure offerte par les résonateurs NEMS, tout en assurant un échange de chaleur avec le gaz à détecter suffisamment important grâce au réseau de nanofilaments chauffants, cet échange de chaleur induisant une variation de la résistance électrique des nanofilaments et donc de l'intensité du courant électrique qui les traverse.

Selon des caractéristiques avantageuses mais optionnelles de l'invention, éventuellement prises en combinaison :
- le capteur comprend au moins deux résonateurs dont les poutres sont agencées le long de deux côtés opposés du réseau de nanofilaments ;
- chaque nanofilament est encastré à ses deux extrémités dans le support ;
- tous les nanofilaments du réseau présentent la même section ;
- la section de chaque nanofilament présente une largeur et une épaisseur comprises chacune entre 10 et 500 nm ;
- chaque nanofilament est agencé à distance d'un nanofilament adjacent ;
- la distance entre deux nanofilaments adjacents est comprise entre 0,5 et 1,5 µm ;
- les poutres présentent une longueur différente de celle des autres nanofilaments ;
- chaque nanofilament est formé d'un matériau semi-conducteur, tel que du silicium ;
- les résonateurs présentent un niveau de dopage différent de celui des autres nanofilaments ;
- le support est formé du même matériau semi-conducteur que les nanofilaments, et le support présente un niveau de dopage différent de celui des nanofilaments autres que les poutres ;
- le support est formé d'un matériau différent de celui des nanofilaments, ledit matériau étant choisi pour isoler thermiquement le réseau de nanofilaments et chaque résonateur du reste du capteur ;
- le matériau du support est poreux ;
- le capteur comprend en outre un substrat par rapport auquel le support est suspendu ;
- le support présente une pluralité de trous traversants s'étendant transversalement à une surface principale du substrat ;
- les nanofilaments autres que les poutres sont reliés les uns aux autres par des pontets ;
- le nombre de nanofilaments est compris entre 10 et 1000 ;
- le dispositif d'actionnement est de type électrostatique ;
- le dispositif de détection comprend une jauge piézorésistive solidaire de la poutre.

L'invention concerne également un capteur de gaz comprenant un capteur de flux thermique tel que décrit plus haut.

L'invention concerne également un système d'analyse de gaz comprenant une colonne de chromatographie et au moins un capteur tel que décrit ci-dessus agencé en sortie de ladite colonne de chromatographie.

L'invention concerne également un débitmètre comprenant un capteur de flux thermique tel que décrit ci-dessus.

### DESCRIPTION DES FIGURES

D'autres caractéristiques et avantages de l'invention ressortiront de la description détaillée qui va suivre, en référence aux dessins annexés sur lesquels :
- la figure 1 est un schéma d'un capteur de flux thermique selon un premier mode de réalisation de l'invention ;
- la figure 2 illustre le schéma électrique de la mesure d'un capteur selon l'invention ;
- la figure 3 est un schéma d'un capteur selon un deuxième mode de réalisation de l'invention ;
- la figure 4 est un schéma d'un capteur selon un troisième mode de réalisation de l'invention ;
- la figure 5 est un schéma d'un capteur selon un quatrième mode de réalisation de l'invention ;
- la figure 6 est un schéma d'un capteur selon un cinquième mode de réalisation de l'invention.

Les signes de référence identiques d'une figure à l'autre identifient des éléments identiques ou remplissant la même fonction. Ces éléments ne sont donc pas décrits en détail à nouveau.

Pour des raisons de lisibilité des figures, les différents éléments du capteur ne sont pas nécessairement représentés à l'échelle.

### DESCRIPTION DETAILLEE DE MODES DE REALISATION DE L'INVENTION

Le capteur de flux thermique comprend un réseau de nanofilaments chauffants qui sont destinés à être mis en contact avec un fluide et à échanger de la chaleur avec ledit fluide pour permettre d'en mesurer une caractéristique.

Les nanofilaments chauffants comprennent un matériau électriquement conducteur présentant une résistivité électrique déterminée ou un matériau semiconducteur ; ils sont connectés, par l'intermédiaire d'un support, à une source électrique adaptée pour porter lesdits nanofilaments à une température déterminée par effet Joule.

Pour optimiser la sensibilité du capteur, le réseau de nanofilaments chauffants est conçu pour permettre un échange maximal de chaleur avec le fluide environnant et limiter au maximum la perte de chaleur avec le support. Les nanofilaments chauffants sont donc avantageusement suspendus par rapport au support, c'est-à-dire qu'un espace libre est ménagé entre chaque nanofilament chauffant et le support pour permettre au fluide d'entourer chaque nanofilament chauffant sur toutes ses faces et de maximiser la surface de contact entre le fluide et le nanofilament chauffant.

Ainsi, dans le cas de l'application à un capteur de gaz, une modification de la composition du gaz environnant le capteur modifie les échanges de chaleur entre les nanofilaments et le gaz, et fait donc varier la température des nanofilaments chauffants ; la mesure de cette température permet d'en déduire la composition du gaz. Dans le cas de l'application à un débitmètre, une variation de vitesse d'un flux de gaz environnant le capteur modifie les échanges de chaleur entre les nanofilaments et le gaz et fait donc également varier la température des nanofilaments.

Le capteur de flux thermique combine ledit réseau de nanofilaments chauffants à au moins un résonateur de type nanosystème électromécanique (NEMS) agencé sur un côté dudit réseau et solidaire du support, ledit résonateur jouant le rôle d'un capteur de température.

De manière connue en elle-même, un tel résonateur NEMS comprend une poutre suspendue par rapport au support, un dispositif d'actionnement apte à générer une vibration de ladite poutre sous l'effet d'un signal d'excitation, et un dispositif de détection configuré pour mesurer un déplacement de ladite poutre au cours de ladite vibration et émettre un signal de sortie présentant une résonance à la fréquence de résonance du résonateur, ladite fréquence de résonance dépendant de la température de la poutre.

La poutre est un des nanofilaments chauffants du réseau, plus précisément un nanofilament situé sur un côté du réseau. Eventuellement, le capteur comprend deux résonateurs NEMS, dont la poutre respective est un nanofilament agencé sur un côté du réseau. La mise en oeuvre de deux résonateurs agencés symétriquement par rapport au réseau présente l'avantage de permettre une mesure différentielle qui simplifie le traitement des signaux de détection et permet d'améliorer le rapport signal sur bruit lors de la détection.

Le matériau des nanofilaments chauffants est caractérisé par un coefficient thermique de résistance (TCR, acronyme du terme anglo-saxon « température coefficient of résistance ») qui définit la variation de sa résistivité électrique en fonction de la température. Par conséquent, une variation de la température du réseau de nanofilaments chauffants par échange thermique avec le fluide environnant provoque une variation de la résistance électrique des nanofilaments et donc la variation de l'intensité du courant électrique qui les traverse. La poutre étant polarisée au même potentiel que les autres nanofilaments, elle subit également une variation du courant électrique qui la traverse, qui affecte fortement la fréquence de résonance du résonateur.

Selon un mode de réalisation préféré, le dispositif d'actionnement est de type électrostatique. Dans ce cas, le dispositif d'actionnement comprend une électrode située d'un côté de la poutre, à distance de celle-ci. Cette distance est de l'ordre de quelques centaines de nm.

Selon un mode de réalisation préféré, le dispositif de détection est de type piézorésistif, comme décrit dans le document FR 2 996 219. Dans ce cas une jauge de contrainte piézorésistive est située sur un côté de la poutre, à distance de ses deux extrémités. Les dimensions de cette jauge sont typiquement de quelques dizaines à quelques centaines de nm de largeur et d'épaisseur et quelques centaines de nm à quelques µm de long. Cependant, l'homme du métier pourrait choisir tout autre type de détection, par exemple capacitive, piézoélectrique, magnétique, optique, etc.

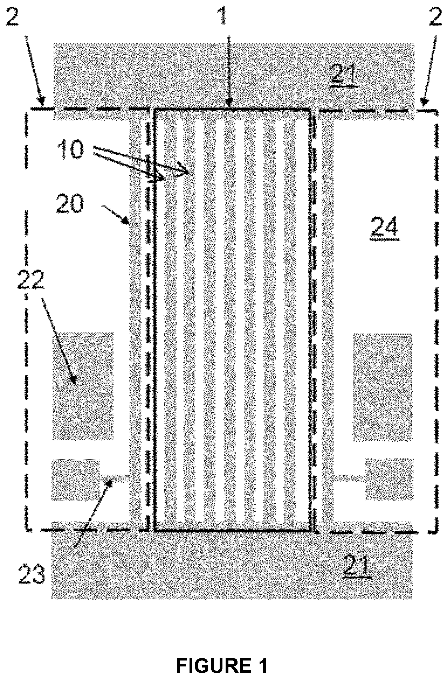

La figure 1 illustre un mode de réalisation du capteur de flux thermique, comprenant deux résonateurs NEMS agencés de part et d'autre du réseau de nanofilaments chauffants.

Le réseau 1 comprend des nanofilaments 10 et deux poutres 20 qui sont deux nanofilaments formant les deux côtés du réseau. Chaque nanofilament est encastré à chacune de ses deux extrémités dans un support 21.

Outre la poutre 20, chaque résonateur 2 comprend un dispositif d'actionnement, représenté sous la forme d'une électrode 22 dans le mode de réalisation illustré, ainsi qu'un dispositif de détection comprenant une jauge piézorésistive 23. Les deux résonateurs sont symétriques par rapport à un axe longitudinal du réseau 1.

Le réseau de nanofilaments est configuré pour présenter une sensibilité importante. A cet effet, le nombre et la dimension des nanofilaments sont choisis pour que le réseau présente une surface d'échange thermique importante avec le fluide environnant. Ainsi, le nombre de nanofilaments chauffants est typiquement compris entre 10 et 1000. Par ailleurs, chaque nanofilament chauffant est agencé à distance d'un nanofilament chauffant adjacent. Par exemple, la distance entre deux nanofilaments adjacents est comprise entre 0,5 et 1,5 µm, par exemple de l'ordre de 1 µm. Par ailleurs, la jonction entre les nanofilaments chauffants et leur support est dimensionnée pour minimiser les pertes thermiques au niveau de cette jonction.

Les dimensions typiques des nanofilaments sont les suivantes : une section dont la largeur et la hauteur sont de quelques dizaines à centaines de nm de côté, et une longueur de quelques µm à quelques dizaines de µm.

Les nanofilaments chauffants peuvent être constitués d'un matériau semiconducteur, tel que du silicium (monocristallin ou polycristallin, dopé ou non), du germanium, du silicium-germanium (SiGe). Eventuellement, le silicium peut être poreux, la porosité permettant d'augmenter les échanges thermiques avec le milieu environnant. De manière avantageuse, les poutres sont réalisées dans le même matériau que les nanofilaments chauffants, éventuellement avec des niveaux de dopage différents choisis de sorte que la résistance électrique des nanofilaments chauffants soit supérieure à celle de la poutre.

Le fait que la poutre de chaque résonateur NEMS soit constituée par un nanofilament chauffant n'implique pas que ladite poutre ait nécessairement des mêmes dimensions que les autres nanofilaments chauffants. En général, la section des poutres est du même ordre que grandeur que celle des nanofilaments car les poutres et les nanofilaments sont de préférence réalisées avec la même technologie. En ce qui concerne la longueur des poutres, elle peut être identique à celle des nanofilaments ou différente. En effet, le choix de la fréquence de résonance du résonateur peut nécessiter le choix d'une longueur de la poutre différente de la longueur des autres nanofilaments chauffants. Typiquement, la fréquence de résonance de chaque résonateur est de quelques MHz à quelques centaines de MHz.

Bien que les nanofilaments chauffants soient représentés rectilignes et parallèles les uns aux autres sur les figures annexées, d'autres modes de réalisation sont possibles. Par exemple, les nanofilaments peuvent ne pas être parallèles les uns aux autres ; par ailleurs, les nanofilaments peuvent présenter une forme non rectiligne, par exemple une forme de serpentin, qui permet d'augmenter la longueur des nanofilaments chauffants tout en relâchant d'éventuelles contraintes de compression.

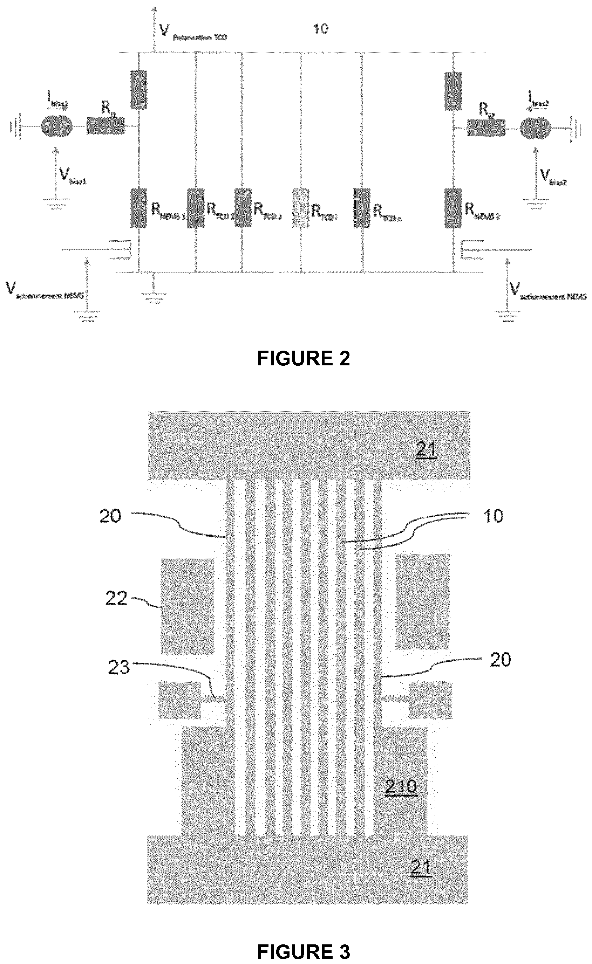

La figure 2 est un schéma électrique du capteur de flux thermique.

Dans ce schéma électrique, chaque nanofilament chauffant est représenté sous la forme d'une résistance électrique notée R_{TCD i} pour le i^{ème} nanofilament, i étant un entier variant entre 1 et n (n étant le nombre total de nanofilaments chauffants en excluant les nanofilaments constituant les poutres des résonateurs). Toutes les résistances électriques présentent sensiblement la même valeur puisque les nanofilaments présentent des dimensions identiques et sont réalisés dans le même matériau.

Dans le schéma électrique, chaque poutre est représentée sous la forme d'une résistance électrique notée R_{NEMS 1} ou R_{NEMS 2}. L'ensemble des poutres et nanofilaments chauffants sont agencés en parallèle et connectés par une extrémité à un premier potentiel (par exemple à la masse) et par l'extrémité opposée à un second potentiel, noté V_{polarisation TCD}.

Chaque poutre est actionnée en vibration à sa fréquence de résonance par une électrode portée à un potentiel V_{actionnement NEMS}. Chaque jauge piézorésistive est représentée sous la forme d'une résistance électrique notée R_{J1} ou R_{J2}. Chaque jauge est polarisée en courant dont l'intensité est respectivement notée I_{bias1} ou I_{bias2}.

Si I_{bias1} (ou I_{bias2}) est très petit devant le produit de R_{NEMS 1} (ou R_{NEMS 2}) et de V_{polarisation TCD}, qui est égal au produit de R_{TCD i} et de V_{polarisation TCD}, alors on considère que R_{NEMS 1} (ou R_{NEMS 2}) est égal à R_{TCD i}.

Lors de la détection d'un gaz, la température du réseau de nanofilaments diminue et le courant électrique traversant le réseau de nanofilaments chauffants et les poutres varie comme les résistances électriques R_{TCD i} = R_{NEMS 1} = R_{NEMS 2}. Cette variation de l'intensité du courant électrique engendre une variation de la fréquence de résonance qui est mesurée par les jauges piézorésistives.

Pour la fabrication de ce capteur, on pourra se référer aux documents FR 2 995 690 et FR 3 008 690 qui décrivent respectivement un procédé de fabrication d'un fil chauffant et un procédé de fabrication d'un résonateur NEMS.

Un procédé de fabrication préféré est basé sur un substrat semiconducteur sur isolant (SOI, acronyme du terme anglo-saxon « Semiconductor on insulator »). Un tel substrat SOI comprend successivement, à partir de sa surface, une couche mince de silicium monocristallin (de quelques centaines de nanomètres d'épaisseur), une couche diélectrique enterrée (par exemple une couche d'oxyde de silicium (SiO₂) et un substrat de base, par exemple en silicium, qui sert de support mécanique au capteur.

Ce procédé met en oeuvre des techniques classiques de la microélectronique, en particulier des techniques de photolithographie, d'implantation, de dépôt et de gravure.

On implante dans la couche mince de silicium des espèces choisies pour obtenir la résistivité électrique souhaitée dans les zones destinées à former respectivement les nanofilaments chauffants et le(s) résonateur(s) (poutre, jauges de contrainte, électrodes d'actionnement). Ces résistivités électriques peuvent éventuellement être différentes entre ces deux zones.

On grave ensuite de manière anisotrope les structures mécaniques (nanofilaments chauffants, résonateur(s) (poutre, jauges de contrainte, électrodes d'actionnement), encastrements, etc.) dans la couche mince de silicium superficielle. Les nanofilaments chauffants et le résonateur sont donc formés d'un seul tenant avec le support dans ladite couche mince, et présentent ainsi la même épaisseur. Les encastrements sont avantageusement réalisés suffisamment grands pour assurer une bonne tenue mécanique vis-à-vis du support après la libération des structures mécaniques. Les encastrements présentent ainsi typiquement des côtés de plusieurs µm à dizaines de µm.

Puis, par des étapes de dépôts et de gravures successives de couches électriquement isolantes (SiO₂) et de couches électriquement conductrices (AISi de préférence pour les interconnexions), on réalise les interconnections métalliques entre les structures mécaniques en silicium dopé.

On peut éventuellement ensuite former une couche planarisante de façon à faciliter l'étape ultérieure de packaging des composants par report d'un capot.

Après avoir ouvert localement (par une gravure anisotrope) cette couche planarisante au-dessus des structures mécaniques destinées à être libérées, on réalise une gravure isotrope de la couche d'oxyde de silicium enterrée du substrat SOI pour libérer les structures mécaniques en silicium destinées à être suspendues (nanofilaments chauffants, résonateur(s)) par rapport au substrat de base. La couche d'oxyde n'est en revanche pas gravée - ou est seulement partiellement gravée - au niveau des encastrements.

On peut alors reporter au-dessus de cette structure un capot comportant un canal gravé, créant ainsi un canal fluidique dans lequel va circuler le mélange gazeux destiné à être analysé.

Ledit canal peut être relié fluidiquement à la sortie d'une colonne de chromatographie gazeuse si une telle colonne est mise en oeuvre en amont du capteur pour séparer et identifier les composés du mélange gazeux.

De manière alternative, le capteur peut être utilisé dans un débitmètre pour mesurer un débit de gaz.

Naturellement, l'homme du métier pourra choisir tout autre procédé de fabrication sans pour autant sortir du cadre de la présente invention.

La figure 3 est un schéma de principe d'un capteur de flux thermique selon une variante du capteur de la figure 1. Par rapport au mode de réalisation de la figure 1, les poutres 20 présentent une longueur différente (inférieure sur la figure) de celle des nanofilaments 10. A cet effet, l'un des supports 21 dans lesquels les nanofilaments sont encastrés présente une extension 210. Une extrémité des poutres est encastrée dans ladite extension 210 tandis que l'autre extrémité est encastrée dans le support 21 opposé.

On peut ainsi optimiser séparément le réseau de nanofilaments et les résonateurs.

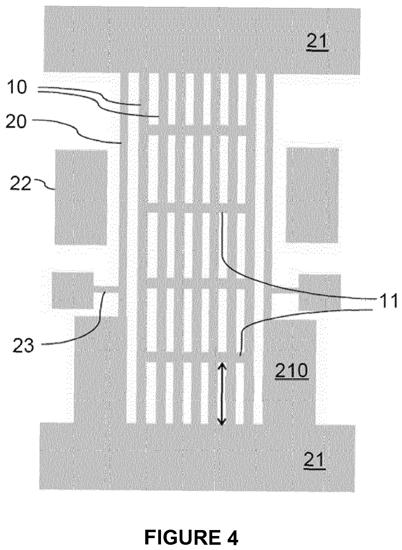

La figure 4 est un schéma de principe d'un capteur de flux thermique selon une variante du capteur de la figure 3. Par rapport au mode de réalisation de la figure 3, les nanofilaments 10 sont reliés mécaniquement par des pontets 11 qui augmentent la rigidité mécanique du réseau 1. Lesdits pontets sont avantageusement réalisés d'un seul tenant avec les nanofilaments lors de la fabrication du réseau. Les pontets s'étendent avantageusement perpendiculairement aux nanofilaments, bien que d'autres agencements des pontets soient envisageables. Par exemple, les pontets peuvent s'étendre parallèlement les uns aux autres avec une distance de l'ordre de 10 µm entre deux pontets adjacents. En revanche, les poutres ne sont pas reliées aux autres nanofilaments par de tels pontets, afin de ne pas rigidifier les poutres et modifier ainsi leur fréquence de résonnance et diminuer la sensibilité des résonateurs.

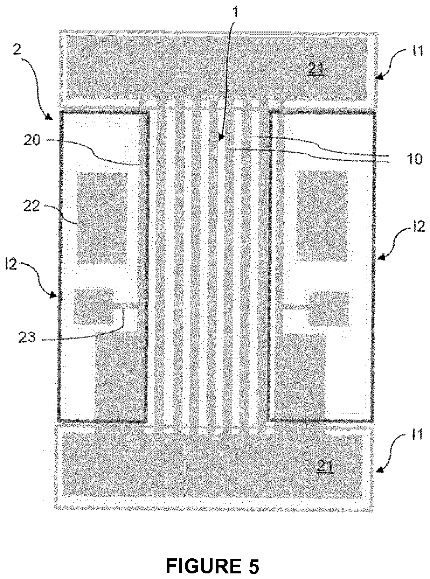

La figure 5 est un schéma de principe d'un capteur de flux thermique selon une variante du capteur de la figure 3. Par rapport au mode de réalisation de la figure 3, le matériau semi-conducteur du support 21, celui des résonateurs 2 (poutres 20 et nanojauges 23) et celui du réseau de nanofilaments sont implantés de manière différenciée afin de régler les résistances électriques de manière différenciée. On pourra par exemple imposer une résistance forte au niveau des nanofilaments 10 qui doivent être chauffés, une résistance plus faible au niveau des supports 21 des nanofilaments et une résistance intermédiaire au niveau des résonateurs 2 en prenant aussi en considération que le niveau de dopage des nanojauges 23 influence le coefficient piézorésistif du matériau et donc le signal de détection de la résonance. Les zones d'implantation sont schématisées par les rectangles l1, l2.

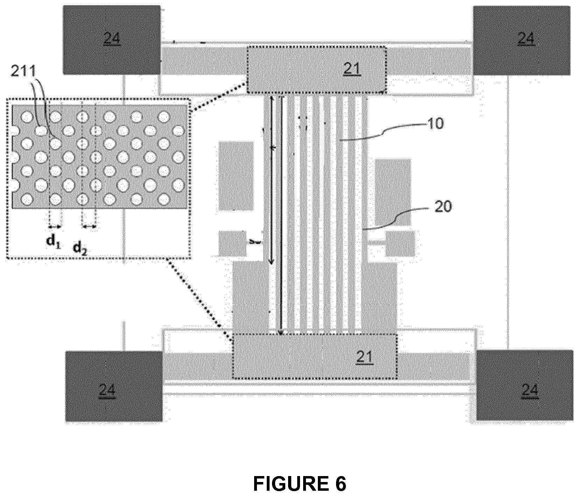

La figure 6 est un schéma de principe d'une forme d'exécution particulière du capteur de flux thermique. La structure constituée du réseau de nanofilaments 10, du résonateur 2 et du support 21 est suspendue par rapport à un substrat 24, ce qui permet de limiter les pertes thermiques au niveau des encastrements. De manière particulièrement avantageuse, le support 21 présente une pluralité de trous 211 traversants s'étendant transversalement à une surface principale du substrat 24. Ces trous 211 sont répartis sur au moins une partie de la surface du support 21. Ces trous peuvent servir lors du procédé de fabrication du capteur, pour faciliter la gravure d'une couche sacrificielle agencée sous le support et les nanofilaments chauffants en vue de libérer le réseau de nanofilaments et le support et les suspendre par rapport au substrat. Dans l'exemple illustré, chaque trou 211 présente un diamètre d₁ de l'ordre de 0,5 µm et est séparé d'un trou adjacent d'une distance d₂ de l'ordre de 2 µm. Même si la figure 6 illustre des trous de taille identique et répartis de manière régulière sur la surface du support, il est également envisageable de faire varier le diamètre des trous et/ou leur densité de répartition afin d'ajuster localement la résistance électrique du support.

Les différents modes de réalisation décrits plus haut peuvent être combinés lorsque cela est techniquement possible.

### REFERENCES

US 8,313,236
FR 2 995 691
FR 2 995 690
FR 2 995 692
WO 2015/082956
FR 2 996 219
FR 3 008 690

## Revendications

1. Capteur de flux thermique comprenant :
- un réseau (1) de nanofilaments (10, 20) suspendus par rapport à un support (21), chaque nanofilament comprenant un matériau électriquement conducteur ou semiconducteur, ledit réseau étant apte à être polarisé par une source électrique pour faire circuler un courant électrique dans chacun desdits nanofilaments,
- au moins un résonateur (2) de type nanosystème électromécanique (NEMS) comprenant :
* une poutre (20) constituée d'un nanofilament formant un côté du réseau,
* un dispositif d'actionnement (22) apte à générer une vibration de ladite poutre (20) sous l'effet d'un signal d'excitation,
* un dispositif de détection configuré pour mesurer un déplacement de la poutre (20) au cours de ladite vibration et émettre un signal de sortie présentant une résonance à la fréquence de résonance du résonateur, ladite fréquence de résonance dépendant de l'intensité du courant électrique traversant la poutre (20),
une variation de température du réseau de nanofilaments chauffants induite par une variation d'une caractéristique d'un fluide environnant ledit réseau provoquant une variation de l'intensité du courant traversant la poutre se traduisant par une variation de la fréquence de résonance dudit résonateur.

2. Capteur selon la revendication 1, comprenant au moins deux résonateurs (2) dont les poutres (20) sont agencées le long de deux côtés opposés du réseau (1) de nanofilaments.

3. Capteur selon l'une des revendications 1 ou 2, dans lequel chaque nanofilament (10, 20) est encastré à ses deux extrémités dans le support (21).

4. Capteur selon l'une des revendications 1 à 3, dans lequel tous les nanofilaments (10, 20) du réseau présentent la même section.

5. Capteur selon l'une des revendications 1 à 4, dans laquelle la section de chaque nanofilament (10, 20) présente une largeur et une épaisseur comprises chacune entre 10 et 500 nm.

6. Capteur selon l'une des revendications 1 à 5, dans lequel chaque nanofilament (10, 20) est agencé à distance d'un nanofilament adjacent.

7. Capteur selon la revendication 6, dans lequel la distance entre deux nanofilaments (10, 20) adjacents est comprise entre 0,5 et 1,5 µm.

8. Capteur selon l'une des revendications 1 à 7, dans lequel les poutres (20) présentent une longueur différente de celle des autres nanofilaments (10).

9. Capteur selon l'une des revendications 1 à 8, dans lequel chaque nanofilament (10) est formé d'un matériau semi-conducteur, tel que du silicium.

10. Capteur selon la revendication 9, dans lequel chaque résonateur présente un niveau de dopage différent de celui des autres nanofilaments (10).

11. Capteur selon l'une des revendications 9 ou 10, dans lequel le support (21) est formé du même matériau semi-conducteur que les nanofilaments (10), et le support (21) présente un niveau de dopage différent de celui des nanofilaments (10) autres que les poutres (20).

12. Capteur selon l'une des revendications 1 à 10, dans lequel le support (21) est formé d'un matériau différent de celui des nanofilaments (10), ledit matériau étant choisi pour isoler thermiquement le réseau de nanofilaments (10) et chaque résonateur (2) du reste du capteur.

13. Capteur selon la revendication 12, dans lequel le matériau du support (21) est poreux.

14. Capteur selon l'une des revendications 1 à 13, comprenant en outre un substrat (24) par rapport auquel le support (21) est suspendu.

15. Capteur selon la revendication 14, dans lequel le support (21) présente une pluralité de trous (211) traversants s'étendant transversalement à une surface principale du substrat.

16. Capteur selon l'une des revendications 1 à 15, dans lequel les nanofilaments (10) autres que les poutres (20) sont reliés les uns aux autres par des pontets (11).

17. Capteur selon l'une des revendications 1 à 16, dans lequel le nombre de nanofilaments (10, 20) est compris entre 10 et 1000.

18. Capteur selon l'une des revendications 1 à 17, dans lequel le dispositif d'actionnement est de type électrostatique.

19. Capteur selon l'une des revendications 1 à 18, dans lequel le dispositif de détection comprend une jauge piézorésistive (23) solidaire de la poutre (20).

20. Capteur de gaz comprenant un capteur de flux thermique selon l'une des revendications 1 à 19.

21. Système d'analyse de gaz comprenant une colonne de chromatographie et au moins un capteur selon l'une des revendications 1 à 19 agencé en sortie de ladite colonne de chromatographie.

22. Débitmètre comprenant un capteur de flux thermique selon l'une des revendications 1 à 19.

## Patentansprüche

1. Thermischer Flusssensor, umfassend:
- ein Netz (1) aus Nanofilamenten (10, 20), die im Verhältnis zu einer Halterung (21) aufgehängt sind, wobei jedes Nanofilament ein elektrisch leitendes oder halbleitendes Material umfasst, wobei das Netz durch eine Stromquelle polarisierbar ist, damit ein elektrischer Strom in jedem der Nanofilamente fließt,
- mindestens einen Resonator (2) vom Typ elektromechanisches Nanosystem (NEMS), der umfasst:
* einen Träger (20), der aus einem Nanofilament besteht, das eine Seite des Netzes bildet,
* eine Betätigungseinrichtung (22), die in der Lage ist, durch ein Anregungssignal eine Vibration des betreffenden Trägers (20) zu erzeugen,
* eine Erkennungsvorrichtung, die ausgelegt ist, um während der Vibration eine Verlagerung des Trägers (20) zu messen und ein Ausgangssignal zu senden, das eine Resonanz in der Resonanzfrequenz des Resonators aufweist, wobei die Resonanzfrequenz von der Stärke des elektrischen Stroms abhängt, der den Träger (20) durchquert, wobei eine Temperaturänderung des Netzes heizender Nanofilamente, die durch eine Änderung einer Eigenschaft eines Fluids in der Umgebung des Netzes hervorgerufen wird, eine Änderung der Stromstärke bewirkt, die den Träger durchquert, die zu einer Änderung der Resonanzfrequenz des Resonators führt.

2. Sensor nach Anspruch 1, umfassend mindestens zwei Resonatoren (2), deren Träger (20) entlang zwei gegenüberliegender Seiten des Nanofilamentnetzes (1) eingerichtet sind.

3. Sensor nach einem der Ansprüche 1 oder 2, wobei jedes Nanofilament (10, 20) an seinen beiden Enden in die Halterung (21) eingebettet ist.

4. Sensor nach einem der Ansprüche 1 bis 3, wobei alle Nanofilamente (10, 20) des Netzes denselben Querschnitt haben.

5. Sensor nach einem der Ansprüche 1 bis 4, wobei der Querschnitt jedes Nanofilaments (10, 20) eine Breite und Dicke von jeweils 10 bis 500 nm aufweist.

6. Sensor nach einem der Ansprüche 1 bis 5, wobei jedes Nanofilament (10, 20) beabstandet von einem benachbarten Nanofilament eingerichtet ist.

7. Sensor nach Anspruch 6, wobei der Abstand zwischen zwei benachbarten Nanofilamenten (10, 20) zwischen 0,5 und 1,5 µm liegt.

8. Sensor nach einem der Ansprüche 1 bis 7, wobei die Träger (20) eine Länge haben, die sich von der der anderen Nanofilamente (10) unterscheidet.

9. Sensor nach einem der Ansprüche 1 bis 8, wobei jedes Nanofilament (10) aus einem Halbleitermaterial wie Silizium besteht.

10. Sensor nach Anspruch 9, wobei jeder Resonator ein Dotierungsniveau aufweist, das sich von dem der anderen Nanofilamente (10) unterscheidet.

11. Sensor nach einem der Ansprüche 9 oder 10, wobei die Halterung (21) aus demselben Halbleitermaterial wie die Nanofilamente (10) besteht und die Halterung (21) ein anderes Dotierungsniveau als die Nanofilamente (10) aufweist, die keine Träger (20) sind.

12. Sensor nach einem der Ansprüche 1 bis 10, wobei die Halterung (21) aus einem Material besteht, das sich von dem der Nanofilamente (10) unterscheidet, wobei dieses Material ausgewählt ist, um das Nanofilamentnetz (10) und jeden Resonator (2) vom Rest des Sensors thermisch zu isolieren.

13. Sensor nach Anspruch 12, wobei das Material der Halterung (21) porös ist.

14. Sensor nach einem der Ansprüche 1 bis 13, der ferner ein Substrat (24) umfasst, im Verhältnis zu dem die Halterung (21) aufgehängt ist.

15. Sensor nach Anspruch 14, wobei die Halterung (21) eine Vielzahl von Durchgangslöcher (211) aufweist, die sich quer zu einer Hauptoberfläche des Substrats erstrecken.

16. Sensor nach einem der Ansprüche 1 bis 15, wobei Nanofilamente (10), die andere als die Träger (20) sind, durch Brücken (11) miteinander verbunden sind.

17. Sensor nach einem der Ansprüche 1 bis 16, wobei die Anzahl der Nanofilamente (10, 20) zwischen 10 und 1000 liegt.

18. Sensor nach einem der Ansprüche 1 bis 17, wobei die Betätigungsvorrichtung elektrostatisch ist.

19. Sensor nach einem der Ansprüche 1 bis 18, wobei die Erkennungsvorrichtung ein piezoresistive Anzeigevorrichtung (23) umfasst, die mit dem Träger (20) fest verbunden ist.

20. Gassensor, der einen thermischen Flusssensor nach einem der Ansprüche 1 bis 19 umfasst.

21. Gasanalysesystem, das eine Chromatographiesäule und mindestens einen Sensor nach einem der Ansprüche 1 bis 19 umfasst, der am Ausgang der Chromatographiesäule eingerichtet ist.

22. Durchflussmesser, der einen thermischen Flusssensor nach einem der Ansprüche 1 bis 19 umfasst.

## Claims

1. Heat flux sensor comprising:
- an array (1) of nanofilaments (10, 20) suspended from a support (21), each nanofilament comprising an electrically conductive or semiconductive material, said array being capable of being biased by an electrical source to cause an electric current to flow through each of said nanofilaments,
- at least one nano-electromechanical system (NEMS) resonator (2) comprising:
* a beam (20) consisting of a nanofilament forming one side of the network,
* an actuating device (22) adapted to generate a vibration of said beam (20) under the effect of an excitation signal,
* a sensing device configured to measure a displacement of the beam (20) during said vibration and output an output signal having a resonance at the resonator resonance frequency, said resonance frequency being dependent on the magnitude of the electric current flowing through the beam (20),
a temperature variation of the heating nanofilament network induced by a variation of a characteristic of a fluid surrounding said network causing a variation of the intensity of the current flowing through the beam resulting in a variation of the resonance frequency of said resonator.

2. The sensor of claim 1, comprising at least two resonators (2) whose beams (20) are arranged along two opposite sides of the nanofilament array (1).

3. The sensor of either claim 1 or 2, wherein each nanofilament (10, 20) is embedded at both ends in the support (21).

4. A sensor according to any of claims 1 to 3, wherein all nanofilaments (10, 20) of the array have the same cross-section.

5. The sensor of any of claims 1 to 4, wherein the cross-section of each nanofilament (10, 20) has a width and a thickness each comprised between 10 and 500 nm.

6. The sensor of any of claims 1 to 5, wherein each nanofilament (10, 20) is arranged at a distance from an adjacent nanofilament.

7. The sensor of claim 6, wherein the distance between two adjacent nanofilaments (10, 20) is between 0.5 and 1.5 µm.

8. The sensor of any of claims 1 to 7, wherein the beams (20) have a different length from that of the other nanofilaments (10).

9. The sensor of any of claims 1 to 8, wherein each nanofilament (10) is formed of a semiconductor material, such as silicon.

10. The sensor of claim 9, wherein each resonator has a different doping level from that of the other nanofilaments (10).

11. The sensor of any of claims 9 or 10, wherein the support (21) is formed of the same semiconductor material as the nanofilaments (10), and the support (21) has a different doping level from that of the nanofilaments (10) other than the beams (20).

12. The sensor according to any of claims 1 to 10, wherein the support (21) is formed of a different material from that of the nanofilaments (10), said material being selected to thermally isolate the nanofilament array (10) and each resonator (2) from the rest of the sensor.

13. The sensor of claim 12, wherein the support material (21) is porous.

14. The sensor of any of claims 1 to 13, further comprising a substrate (24) with respect to which the support (21) is suspended.

15. The sensor of claim 14, wherein the substrate (21) has a plurality of through holes (211) extending transversely to a main surface of the substrate.

16. The sensor of any of claims 1 to 15, wherein the nanofilaments (10) other than the beams (20) are connected to each other by bridges (11).

17. The sensor of any of claims 1 to 16, wherein the number of nanofilaments (10, 20) is between 10 and 1000.

18. The sensor of any of claims 1 to 17, wherein the actuating device is of the electrostatic type.

19. The sensor of any of claims 1 to 18, wherein the sensing device comprises a piezoresistive gauge (23) integral with the beam (20).

20. A gas sensor comprising a heat flux sensor according to any of claims 1 to 19.

21. A gas analysis system comprising a chromatography column and at least one sensor according to any of claims 1 to 19 arranged at the outlet of said chromatography column.

22. A flow meter comprising a heat flux sensor according to any of claims 1 to 19.
